# EUROPEAN PATENT APPLICATION

(11) **EP 1 930 773 A1**
(43) Date of publication of application: **11.06.2008**
(21) Application number: 07122601.3
(22) Date of filing: 07.12.2007
(51) Int. Cl.: G03F 7/20

(54) **Substrate support and lithographic process**

(30) Priority: 08.12.2006 US 635789
(71) Applicant: ASML Netherlands BV, 5504 DR Veldhoven (NL)
(72) Inventor: Hennus, Pieter Renaat Maria, B-3990, Peer (BE); van der Meulen, Frits, 5646 JG Eindhoven (NL); Ottens, Joost Jeroen, 5501 BG Veldhoven (NL); Steijaert, Peter Paul, 5653 CM Eindhoven (NL); Steijns, Hubert Matthieu Richard, 5508 DD Veldhoven (NL); Smits, Peter, 5991 KD Baarlo (NL)
(74) Representative: Hatzmann, Martin

(57) **Abstract**

A substrate support constructed to support a substrate for immersion lithographic processing is disclosed. The substrate support has a central part and a peripheral part, the peripheral part comprising an extraction duct configured to extract a liquid from a top surface of the substrate support, the extraction duct connected to an exit duct configured to duct the liquid away from the substrate support. The substrate support further includes a thermal decoupler, arranged in the peripheral part, configured to arranged to decrease heat transport between the central part and the peripheral part.

## Description

### Field

The present invention relates to a substrate support for supporting a substrate during immersion lithographic processing and to a lithographic process.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.
There is an increased need for control of the substrate temperature, due to ever more demanding requirements for image resolution, in particular in the new field of immersion lithography. Typically the substrate is supported by a substrate support and the immersion liquid is removed via a peripheral part of the substrate support. During the removal of the immersion liquid a part of the liquid may vaporize inducing a heat load to the peripheral part of the substrate support leading to a temperature gradient of the substrate.

### Summary

It is desirable, to provide a substrate support where an improved thermal stabilization of the substrate is provided, near the edge of the substrate.
According to an aspect of the invention, there is provided a substrate support for supporting a substrate during immersion lithographic processing, the substrate support comprising:
a central part; and
a peripheral part positioned around the central part;
characterized by
a thermal decoupler arranged to decrease heat transport between the central part and the peripheral part.
According to an aspect of the invention, there is provided a lithographic process comprising the steps of
- providing a substrate support for supporting a substrate;
- predicting the heat load experienced by the substrate support during a later step of the lithographic process;
- supplying a fluid to the substrate support;
- ducting the fluid through a duct of the substrate support;
- estimating a temperature change to the fluid between supplying the fluid to the substrate support and the fluid being ducted along a control position in the duct, based on the predicted heat load to the substrate support;
- during the later step, arranging the fluid to have a desired temperature at the at the control position by giving the fluid an offset to the desired temperature before supplying it to the substrate support, the offset corresponding to the estimated temperature change.

### Brief Description of the Drawings

Embodiments of the invention will now be described, by way of example only, with reference to the accompanying schematic drawings in which corresponding reference symbols indicate corresponding parts, and in which:

Figure 1 depicts a lithographic apparatus according to an embodiment of the invention;

Figure 2 depicts a portion of a substrate table according to an embodiment;

Figure 3 depicts a portion of substrate table, in plan, according to an embodiment;

Figure 4 depicts a portion of a substrate table, in plan, according to an embodiment; and

Figure 5 illustrates a duct configuration for a substrate table according to an embodiment.

### Detailed Description

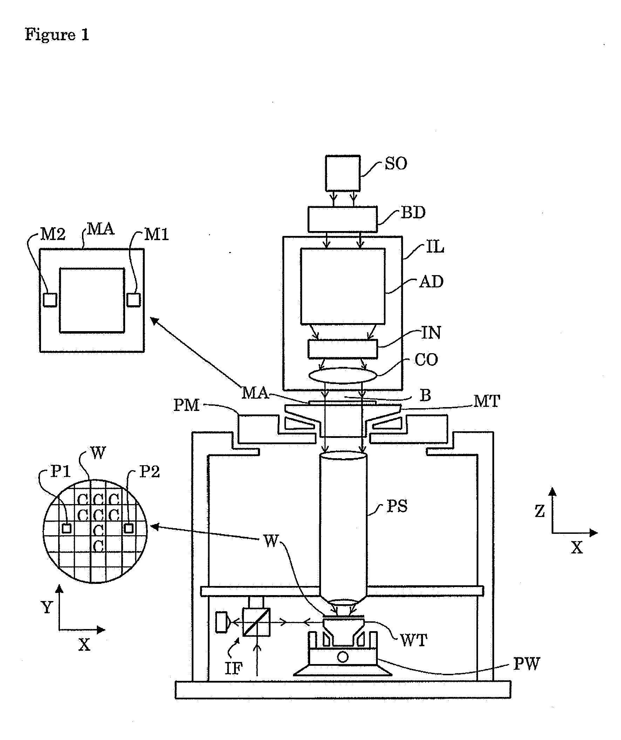

Figure 1 schematically depicts a lithographic apparatus according to one embodiment of the invention. The apparatus comprises:

- an illumination system (illuminator) IL configured to condition a radiation beam B (e.g. UV radiation);

- a support structure (e.g. a mask table) MT constructed to support a patterning device (e.g. a mask) MA and connected to a first positioner PM configured to accurately position the patterning device in accordance with certain parameters;

- a substrate table (e.g. a wafer table) WT constructed to hold a substrate (e.g. a resist-coated wafer) W and connected to a second positioner PW configured to accurately position the substrate in accordance with certain parameters; and

- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid (or immersion fluid) or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more support structures). In such '"multiple stage" machines, the additional tables and/or support structures may be used in parallel, or preparatory steps may be carried out on one or more tables and/or support structures while one or more other tables and/or support structures are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The depicted apparatus could be used in at least one of the following modes:

1. In step mode, the support structure MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2.In scan mode, the support structure MT and the substrate table WT are scanned synchronously while a pattern imparted to the radiation beam is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to mask less lithography that utilizes programmable patterning device, such as a programmable mirror array of a type as referred to above.

Combinations and/or variations on the above described modes of use or entirely different modes of use may also be employed.

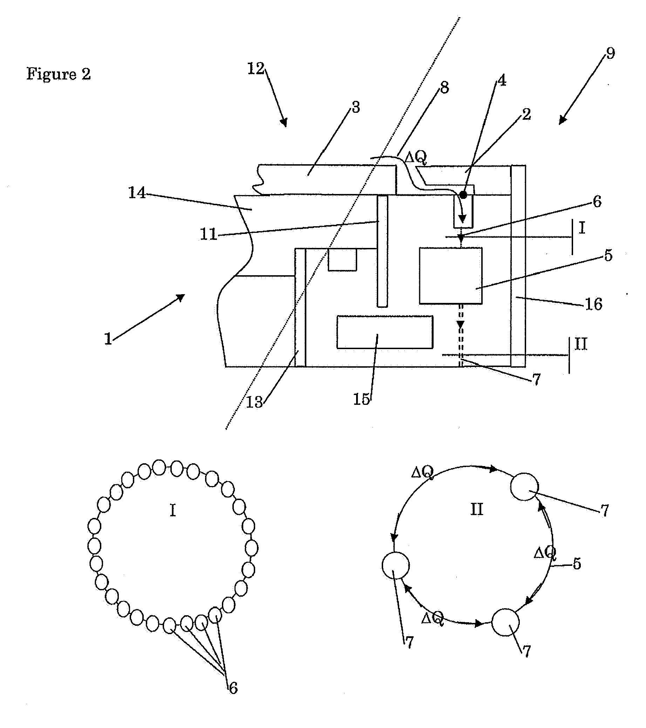

In an embodiment of the invention (Figure 2) a substrate support, here a substrate table, is constructed to support a substrate for immersion lithographic processing purposes. Figure 2 shows a peripheral part of the substrate table 1 attached to a partly shown central part, according to the embodiment of the invention. In addition, schematically, cross-sectional views over the entire periphery of the substrate table 1 along the lines I and II are shown in Figure 2I and Figure 2II. A piece 2 (e.g., annular shape) is provided to be arranged in line with and to extend along the periphery of a substrate 3. The piece 2 forms a gap 4 together with an edge of the substrate 3. Through the gap 4, immersion liquid will enter extraction duct 5, via vertical channels 6 depicted in Figure 2I, provided at a regular spacing distance along the entire peripheral length of the extraction duct 5.

The extraction duct 5 is connected to an exit channel system 7, schematically illustrated in Figure 2II. By providing a powerful gas flow 8, splashing or contamination by immersion liquid on or near the substrate 3 may be prevented. However, typically, the gas flow 8 may provide a considerable thermal load ΔQ to the peripheral part 9 of the substrate 3 and substrate table 1, due to a phase transition of the immersion liquid stimulated by the gas flow 8. Furthermore, the exit channel system 7 may break a symmetry of the substrate table 1, where in principle over the entire periphery of the substrate 3 immersion liquid can be entered in the extraction duct 5 (see Figure 2I). Exiting of the immersion liquid via exit channel system 7 may therefore not be uniform, due to a local presence of an immersion hood (not shown) near a periphery of the substrate 3. Further, the exit channel system 7, in the vertical connection only exits in a limited number of places, typically, one to six positions over the entire periphery. This may amount to local thermal load ΔQ, through the uneven flows present in the extraction duct 5. The indicated local thermal loads may give rise to a local thermal distortion near the periphery of the substrate 3. In order to prevent or reduce this, according to an aspect of the invention, a thermal decoupler in the form of an insulator edge 11 is arranged at the peripheral part 9 of the substrate table 1.

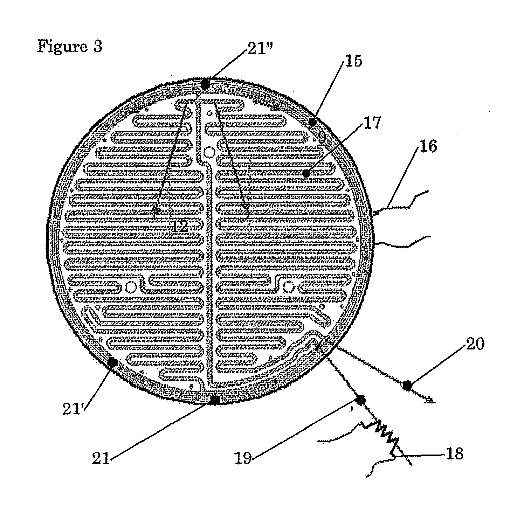

Accordingly, peripheral thermal loads ΔQ are kept local to the peripheral part 9 and are limited in affecting a central part 12 of the substrate table 1. In addition to the insulating piece 11, other isolating pieces may be present at a different radial distance measured from a centre of the substrate table 1, such as is shown in Figure 2. Here a first insulator edge 11 is shown that thermally separates the gap 4 from the central part 12. A second insulator edge 13 (e.g., an annulus) is shown further towards the centre of the table and covered by a substrate support layer 14. The second edge 13 follows a peripheral duct 15 which may be provided in the peripheral part 9 of the substrate table 1. This will be further described with reference to Figures 3 to 5. An edge heater 16 may be present, for example, formed by electric wiring to provide thermal energy to the peripheral part 9 of the substrate table 1. Desirably, the insulator 11 and/or 13 is/are formed from a glass-like material, air, vacuum, a foam glass and/or a polymer. In an embodiment, alternatively or in addition, the insulator is formed of a material having a relatively low stiffness, to mechanically isolate the peripheral part 9 from the central part 12. This may further enhance the mechanical stability of the central part 12 of the substrate table 1 since mechanical deformations of the peripheral part 9 are substantially prevented from being transferred to the central part 12 of the substrate table 1 and thus better imaging quality may be achieved when the substrate 3 is processed in a lithographic process.

In an embodiment (figure 3 in particular in conjunction with figure 2), thermal conditioning is provided by circulating a thermal buffering liquid (typically water with one or more possible additives) through a plurality of central ducts 17. More generally the thermal buffering liquid functions as a liquid medium and may be a fluid medium. The plurality of central ducts 17 run through the substrate table 1, typically in a pattern as shown, however, other patterns may be possible. The peripheral part 9 is thermally conditioned through a peripheral duct 15. The liquid in the ducts 15, 17 can be heated by a thermal energy controller 18, which may provide heat to the liquid as a function of a measured input and output temperature. In an embodiment, this thermal energy controller may function as a cooler, to extract heat from the liquid, depending on necessity, especially when controlled actively. To this end, a thermal sensor arrangement, in this embodiment comprising input temperature sensor 19 and an output temperature sensor 20, is provided in a flow path of the liquid. Typically, the liquid circulates through the entire substrate table 1, including central 12 and peripheral parts 9. Therefore, the sensors 19 and 20 control the total amount of energy to be input in the liquid, which is carried out by thermal energy controller 18. To further condition the edge part 9, additionally, an edge heater 16 may be provided, as also described with reference to Figure 2. The edge heater 16 is typically controlled in response to edge temperature sensors 21, 21', 21" which are mounted in the edge part 9 at predetermined locations in the substrate table edge part 9.

The embodiment in Figure 3 may have a problem in determining a correct amount of heat to be supplied to the peripheral part 9 since the edge temperature sensors 21, 21', 21" are directly mounted on the substrate table 1. Accordingly, local phenomena giving rise to thermal effects, such as a presence of a droplet in the vicinity of the temperature sensor may significantly influence a temperature value measured by one or more of the sensors. Accordingly, it may be difficult to provide a correct amount of heat with the edge heater 16 which is designed as an edge thermal balancer globally around the periphery of the substrate table 1. Further, the measured temperature of the liquid, measured by the input and output temperature sensors 19, 20, may be significantly influenced by thermal effects at the edge of the table 9. It may therefore be difficult to distinguish edge effects and effects in the central part 12 of the substrate table 1.

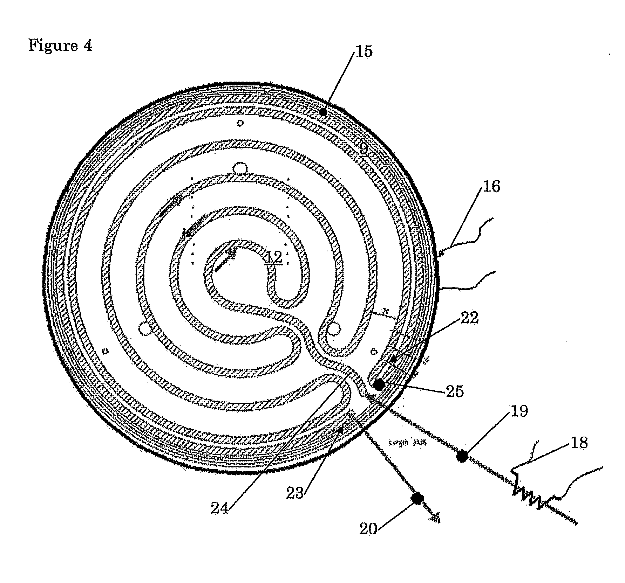

Alternatively (figure 4), according to an embodiment of the invention, a thermal sensor arrangement is provided in or near the peripheral duct 15 for calculating the amount of energy to be applied by the thermal energy controller 18. The thermal sensor arrangement comprises desirably at least two temperature sensors distanced from each other at predetermined locations. In the illustrated embodiment, the predetermined locations are located near an input 22 and an output 23 of the duct 15. In an embodiment, a temperature control can be provided by connecting the duct 15 and a central duct 24 that meanders through a central part of the substrate table. In the shown embodiment the central duct 24 is in thermal connection with the thermal energy controller 18 to supply temperature control to the central duct 24. A supply system and reception system are not shown but implicitly present.

In this embodiment (figure 4), thermal control can be carried out with three sensors 19, 20 and 25, provided in a single duct 24 that is directed to the central part 12, and which is connected to the peripheral duct 15. In this embodiment a liquid medium is used as fluid medium, but a gas may be applied as well as medium. In this duct, the overall input temperature can be measured by an input temperature sensor 19 and the output temperature can be measured by output temperature sensor 20. In this way, the overall thermal energy to be applied to the liquid medium can be controlled by thermal energy controller 18 (being either supply heater and/or cooler), based on temperature signals from the input sensor 19 and the output sensor 20, to stabilize the central part 12 of the substrate table 1. The temperature of the liquid medium when input into the duct 15 can be measured by a single edge temperature sensor 25. In an example, the mean temperature of the liquid medium (e.g., water) can be kept at a fixed mean temperature of, for example, 22 °C, that is, ½ (T_{liqiud,in} + T_{liquid,out}). This minimizes changes in scaling for varying loads to the core of the substrate table due to, for example, different exposure recipes (immersion hood load variations).

With the edge temperature sensor 25 provided in or near the input of the duct 15, the edge heater 16 can be controlled by temperature signals from the edge temperature sensor 25 and the output temperature sensor 20. Desirably, the temperature differences in the edge are kept minimal, therefore, the control goal will preferably be in such a way that (T_{liquid,out} = T_{liquid,edge}) to compensate global edge loads.

In an embodiment, a control unit is configured to control the fluid medium temperature such that the central part of the substrate support has a first temperature and the peripheral part has a second temperature. In this embodiment, in an outward direction, two different temperature gradients are expected in the substrate support 1. The outward direction corresponds to going from the middle of the central part of the substrate support to the peripheral part of the substrate support. In this embodiment the temperature is expected to rise in the outward direction in the central part and to fall in the outward direction in the peripheral part. Where the central part and the peripheral part are connected, the temperatures are intended to be equal to minimize heat transport. However the mean temperature of the central part differs from the mean temperature of the peripheral part as the central part and peripheral part are exposed to different heat loads due to the lithographic processing.

In the embodiment, the central part is subjected to an output heat load by a central heat load generator, i.e. the central duct 24. The peripheral part is subjected to an output head load by a peripheral head load generator, i.e. edge heater 16. This provides the option to provide high level control the heat transport between the central part and the peripheral part of the substrate support thereby decreasing the requirements for the thermally insulating edges 11,13.

The embodiment encompasses the situation wherein the fluid medium from the central duct 24 supplies the peripheral duct 15. The embodiment also encompasses the situation wherein the heat loads by the fluid medium and the edge heater are determined by expected minimum and maximum lithographic processing heat loads or by measurements at different positions in the substrate support.

Although Figure 4 shows a sensor arrangement with only a single edge sensor 25, multiple sensors may be provided in the duct 15, in particular, to cope with asymmetric loads of the immersion hood when locally present near an edge of the substrate table. Typically, local heating may also be provided in such cases. As with the embodiment of Figure 2, this embodiment provides an advantage of increased control. This is because the applied heat and thermal effects will be bounded to the peripheral part 9 due to insulator 11 and therefore more accurately measurable by the temperature sensors 19, 20 and 25. Accordingly a more sensitive temperature control system may be provided. This is also true for the embodiment depicted in Figure 3. In addition, although Figure 4 shows a substrate table wherein the central duct and the peripheral duct form a single connected duct, multiple parallel ducts may also or alternatively be provided, wherein a branch would be arranged to provide temperature balancing to an edge part 9 and another branch would be arranged to provide temperature balancing to a central part 12.

Furthermore, conventionally, a liquid is conditioned to a preset supply temperature equal to a set temperature of the substrate support 1, in particular to about 22°C (= the optimal system temperature, based on desired projection system temperature). Accordingly, the temperature set point of the supply medium is conventionally not based on expected heat load towards the liquid. As a result, the temperature of the return liquid is likely to be higher than the optimal system temperature. In addition, the average tool temperature and average component temperature may vary with different modes of operation of the lithographic system. Both effects may result in machine performance loss. According to an aspect of the invention, the fluid medium supply temperature is at a temperature lower than a set temperature, in such a manner that the average fluid medium temperature (supply vs. return) will be the set temperature, in particular, of about 22°C. In this way, the effect of the heat input from (a) fluid lines and/or (b) components may be reduced or minimized. According to an aspect, two ways of implementing this principle are foreseen: 1) a fixed fluid medium supply temperature having a set point temperature, based on, e.g., a maximum heat load towards (part of) the fluid medium system so that the average temperature of supply and return fluid medium will be closer to the set point of 22°C; and/or 2) the fluid medium supply temperature is controlled actively. In this way, variations due to varying power consumption / heat load can be dealt with.

These aspects may be combined in the embodiment depicted in Figure 4, by reversing the flow of the fluid medium as depicted, so that the fluid medium supply temperature is controlled by thermal energy controller 18 (which may have a heating and/or cooling function) to a temperature that is actively controlled by controller 18 to a preset temperature measured by the edge temperature sensor 25 and controlled to a preset temperature below the set temperature of the central part 12, to comply with an expected or measured heat load of the substrate support 1.

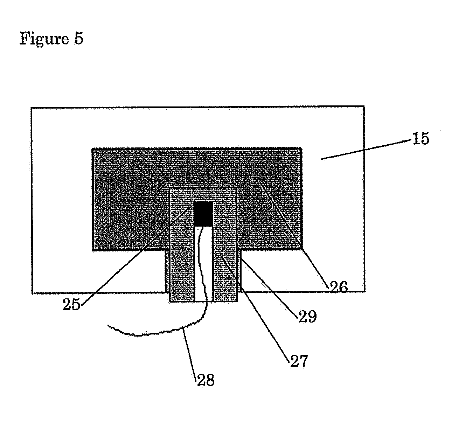

Figure 5 schematically shows an embodiment of duct 15 provided with a temperature sensor 25. Typically, the duct 15 is provided with conductive walls to be able to transport heat into the fluid medium 26. The sensor 25 is desirably enclosed in a thermally conductive seal 27, which protects the sensor 25 and wiring 28 from the liquid 26. Also, desirably, the lower sides of the sensor 25 not in thermal contact with the fluid medium are thermally isolated by isolating material 29.

Although the illustrated embodiments refer to a substrate support to be used to hold a substrate to be targeted with a patterned beam, the structure may be very well applied to a patterning device support structure or any other support that needs thermal stabilization.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In an embodiment for imprint lithography topography present on a patterning device is pressed into a layer of resist supplied to the substrate whereupon the resist is cured by applying heat. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

One or more embodiments of the invention may be applied to any immersion lithography apparatus, in particular, but not exclusively, those types mentioned above and whether the immersion liquid is provided in the form of a bath or only on a localized surface area of the substrate. A liquid supply system as contemplated herein should be broadly construed. In certain embodiments, it may be a mechanism or combination of structures that provides a liquid to a space between the projection system and the substrate and/or substrate table. It may comprise a combination of one or more structures, one or more liquid inlets, one or more gas inlets, one or more gas outlets, and/or one or more liquid outlets that provide liquid to the space. In an embodiment, a surface of the space may be a portion of the substrate and/or substrate table, or a surface of the space may completely cover a surface of the substrate and/or substrate table, or the space may envelop the substrate and/or substrate table. The liquid supply system may optionally further include one or more elements to control the position, quantity, quality, shape, flow rate or any other features of the liquid.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. Substrate support for supporting a substrate during immersion lithographic processing, the substrate support comprising:
a central part; and
a peripheral part positioned around the central part;
**characterized by**
a thermal decoupler (11,13,15) arranged to decrease heat transport between the central part and the peripheral part.

2. Substrate support of claim 1, wherein the peripheral part comprises extraction means (5,6,7) arranged to extract an immersion fluid from a top surface of the substrate support.

3. Substrate support of claim 2, wherein the thermal stabilizer comprises an isolator arranged centrally relative to the extraction means to thermally and/or mechanically isolate the peripheral part from the central part.

4. Substrate support of claim 3, wherein the isolator comprises a glass-like material, air, vacuum, a foam glass and/or a polymer.

5. Substrate support of any of claims 1 to 4, comprising a peripheral duct arranged to duct a fluid medium through the peripheral part and connected to a supply system arranged to control the temperature of the fluid medium.

6. Substrate support of claim 5, wherein the supply system is arranged to control the temperature of the fluid medium to a temperature which differs from a desired temperature of the peripheral part of substrate support.

7. Substrate support of claim 6, wherein the supply system is arranged to control the temperature of the fluid medium at a fixed difference with respect to a desired temperature of the substrate support.

8. Substrate support of claim 6, wherein the supply system is arranged to control the temperature of the fluid medium based on the desired temperature of the substrate support and an expected heat load to the substrate support.

9. Substrate support according to claim 5, comprising
- an edge temperature sensor (25) arranged to measure a temperature of the fluid medium at an input of the peripheral duct; and
- an output temperature sensor (20) arranged to measure a temperature of the fluid medium at an output of the peripheral duct;
- an edge heater arranged to heat the peripheral part; and
and a controller connected to the edge temperature sensor and the output temperature sensor, the controller being arranged to control the amount of heat output by the edge heater based on the difference between the measured temperature of the fluid medium at the input of the peripheral duct and at the output of the peripheral duct.

10. Substrate support according to claim 5 or 9, wherein the peripheral duct is supplied with the fluid medium via a central duct that meanders through the central part.

11. Substrate support according to claim 9 and 10, wherein the controller is arranged to control the temperature of the fluid medium based on the measured temperature of the fluid medium at the input of the peripheral duct and the measured temperature at the output of the peripheral duct.

12. Substrate support according to any of the claims 1 to 11, comprising a central heat load generator in the central part for generating a central heat load output and a peripheral heat load generator in the peripheral part for generating a peripheral heat load output wherein the central and the peripheral heat load generators are controlled by a control unit arranged to control the central heat load output and the peripheral heat load output individually.

13. Lithographic apparatus comprising the substrate support according to the combination of any of the claims 1,3,4,5,6,7,8,9,10,11,12 and claim2, comprising a projection system configured to project a patterned radiation beam onto a target portion of the substrate and wherein the apparatus is arranged to provide the immersion fluid between the substrate support and the projection system.

14. Lithographic apparatus according to claim 13, wherein the extraction duct is annular.

15. Lithographic process comprising the steps of
- providing a substrate support for supporting a substrate;
- predicting the heat load experienced by the substrate support during a later step of the lithographic process;
- supplying a fluid to the substrate support;
- ducting the fluid through a duct of the substrate support;
- estimating a temperature change to the fluid between supplying the fluid to the substrate support and the fluid being ducted along a control position in the duct, based on the predicted heat load to the substrate support;
- during the later step, arranging the fluid to have a desired temperature at the at the control position by giving the fluid an offset to the desired temperature before supplying it to the substrate support, the offset corresponding to the estimated temperature change.

16. Lithographic process according to claim 15, wherein the later step comprises illuminating the substrate supported by the substrate support with a patterned beam of radiation.

17. Lithographic process according to any of the claims 15 or 16, wherein the offset is fixed during the process.

18. Lithographic process according to any of the claims 15 to 17, wherein the estimated temperature change is based on temperature measurements of the substrate table.

19. Lithographic process according to claim 18, wherein the temperature measurements of the substrate table are made while subjecting a further substrate to the later step of the process.
